# EUROPEAN PATENT APPLICATION

(11) **EP 4 415 040 A1**
(43) Date of publication of application: **14.08.2024**
(21) Application number: 21959953.7
(22) Date of filing: 08.10.2021
(51) Int. Cl.: H01L 23/48, H01L 25/07

(54) **SEMICONDUCTOR MODULE AND METHOD FOR MANUFACTURING SAME**

(71) Applicant: MITSUBISHI ELECTRIC CORPORATION, Chiyoda-ku Tokyo 100-8310 (JP)
(72) Inventor: TAKEUCHI, Kensuke, Tokyo 102-0073 (JP)
(74) Representative: Hoffmann Eitle
(86) International application number: PCT/JP2021/037277
(87) International publication number: WO 2023/058211

(57) **Abstract**

This semiconductor module includes: a plurality of base plates (50) made of conductive members and formed in plate shapes; at least one semiconductor element joined to a one-surface side of at least one of the base plates (50); and at least one connection member (45) made of a conductive member and connecting one-surface sides of two or more of the base plates (50). The plurality of base plates (50) are arranged with gaps therebetween on the same plane. The connection member (45) has one or both of a semiconductor element connection portion which is a part connected to the base plate (50) via the semiconductor element, and a base plate connection portion which is a part directly connected to the base plate (50).

## Description

### TECHNICAL FIELD

The present disclosure relates to a semiconductor module and a method for manufacturing the same.

### BACKGROUND ART

In a device for performing power conversion, or the like, a semiconductor module including an electronic component and a semiconductor element such as a semiconductor switching element is used. The semiconductor module is formed such that semiconductor switching elements are mounted on base plates made of conductive members, electrode pads provided at upper surfaces of a plurality of semiconductor switching elements are connected via connection members or bonding wires, and then these are sealed with mold resin (see, for example, Patent Document 1). A plurality of terminal portions such as positive and negative power supply terminals, output terminals to a load, and control terminals for controlling the semiconductor switching elements are arranged at side surfaces around the outer periphery of the mold resin. Inside the semiconductor module, shunt resistors for current detection, and the like, are also mounted in addition to the plurality of semiconductor switching elements.

### CITATION LIST

### PATENT DOCUMENT

Patent Document 1: WO2012/137333

### SUMMARY OF THE INVENTION

### PROBLEM TO BE SOLVED BY THE INVENTION

In the internal structure of the semiconductor module in Patent Document 1, the base plate and the semiconductor switching element provided on the base plate are connected via the connection member. In this configuration, in a case of needing a circuit configuration in which a semiconductor switching element at one part is removed in the semiconductor module, another base plate with a circuit configuration changed is needed. In addition, in a case of removing a different semiconductor switching element, still another base plate is needed. Therefore, in the internal structure of the semiconductor module in Patent Document 1, design change involving change of the base plate is needed in accordance with change of the circuit configuration involving removal of a semiconductor switching element, thus having a problem that the base plate cannot be used in common. In addition, since the base plate cannot be used in common, product-by-product individual semiconductor modules are needed, and thus there is a problem that production efficiency is low.

Accordingly, an object of the present disclosure is to provide a semiconductor module that enables a base plate to be used in common, thus improving productivity.

### MEANS TO SOLVE THE PROBLEM

A semiconductor module according to the present disclosure includes: a plurality of base plates made of conductive members and formed in plate shapes; at least one semiconductor element joined to a one-surface side of at least one of the base plates; and at least one connection member made of a conductive member and connecting one-surface sides of two or more of the base plates. The plurality of base plates are arranged with gaps therebetween on the same plane. The connection member has one or both of a semiconductor element connection portion which is a part connected to the base plate via the semiconductor element, and a base plate connection portion which is a part directly connected to the base plate.

A method for manufacturing a semiconductor module according to the present disclosure includes: a member preparation step of preparing a plurality of base plates which are made of conductive members and formed in plate shapes and which are arranged with gaps therebetween on the same plane, at least one semiconductor element, and at least one connection member made of a conductive member; and a connection step of connecting one-surface sides of two or more of the base plates by the connection member via the semiconductor element or not via the semiconductor element. In the connection step, a plurality of connection parts between the base plates and the connection member are each connected by an indirect connection method so as to be connected via the semiconductor element or by a direct connection method so as to be directly connected not via the semiconductor element, and a first connection step of performing connection for the plurality of connection parts by a first setting pattern of the indirect connection method and the direct connection method, and a second connection step of performing connection for the plurality of connection parts by a second setting pattern of the indirect connection method and the direct connection method, which is different from the first setting pattern, are executed.

### EFFECT OF THE INVENTION

The semiconductor module according to the present disclosure includes: the plurality of base plates; the at least one semiconductor element joined to the one-surface side of the at least one base plate; and the at least one connection member connecting the one-surface sides of the two or more base plates. The plurality of base plates are arranged with gaps therebetween on the same plane. The connection member has one or both of the semiconductor element connection portion which is a part connected to the base plate via the semiconductor element, and the base plate connection portion which is a part directly connected to the base plate. Thus, the base plates can be used in common even for semiconductor modules that are different in the number of semiconductor elements joined to the base plates and connected to the connection member. Since the base plates are used in common, the semiconductor module is not a product-by-product individual semiconductor module, so that productivity of the semiconductor module can be improved.

The method for manufacturing the semiconductor module according to the present disclosure includes: the member preparation step; and the connection step of connecting the one-surface sides of the two or more base plates by the connection member via the semiconductor element or not via the semiconductor element. In the connection step, the plurality of connection parts between the base plates and the connection member are each connected by the indirect connection method so as to be connected via the semiconductor element or by the direct connection method so as to be directly connected not via the semiconductor element, and the first connection step of performing connection for the plurality of connection parts by the first setting pattern of the indirect connection method and the direct connection method, and the second connection step of performing connection for the plurality of connection parts by the second setting pattern of the indirect connection method and the direct connection method, which is different from the first setting pattern, are executed. Thus, the base plates can be used in common even for semiconductor modules that are different in the number of semiconductor elements joined to the base plates and connected to the connection member. Since the base plates are used in common, the semiconductor module is not a product-by-product individual semiconductor module, so that productivity of the semiconductor module can be improved.

### BRIEF DESCRIPTION OF THE DRAWINGS

[FIG. 1] FIG. 1 shows a circuit configuration of a device including a semiconductor module according to embodiment 1.
[FIG. 2] FIG. 2 is a plan view of the semiconductor module according to embodiment 1.
[FIG. 3] FIG. 3 is a plan view of another semiconductor module according to embodiment 1.
[FIG. 4] FIG. 4 is a sectional view of the semiconductor module taken at an A-A cross-section position in FIG. 3.
[FIG. 5] FIG. 5 is a plan view of another connection member of the semiconductor module according to embodiment 1.
[FIG. 6] FIG. 6 is a plan view of another semiconductor module according to embodiment 1.
[FIG. 7] FIG. 7 is a plan view of another connection member of the semiconductor module according to embodiment 1.
[FIG. 8] FIG. 8 illustrates the connection member of the semiconductor module according to embodiment 1.
[FIG. 9] FIG. 9 is a sectional view of another connection member of the semiconductor module according to embodiment 1.
[FIG. 10] FIG. 10 is a plan view of another semiconductor module according to embodiment 1.
[FIG. 11] FIG. 11 is a side view of the other semiconductor module according to embodiment 1.
[FIG. 12] FIG. 12 shows a manufacturing process for the semiconductor module according to embodiment 1.

### DESCRIPTION OF EMBODIMENTS

Hereinafter, a semiconductor module according to embodiments of the present disclosure will be described with reference to the drawings. In the drawings, the same or corresponding members or parts are denoted by the same reference characters, to give description.

### Embodiment 1

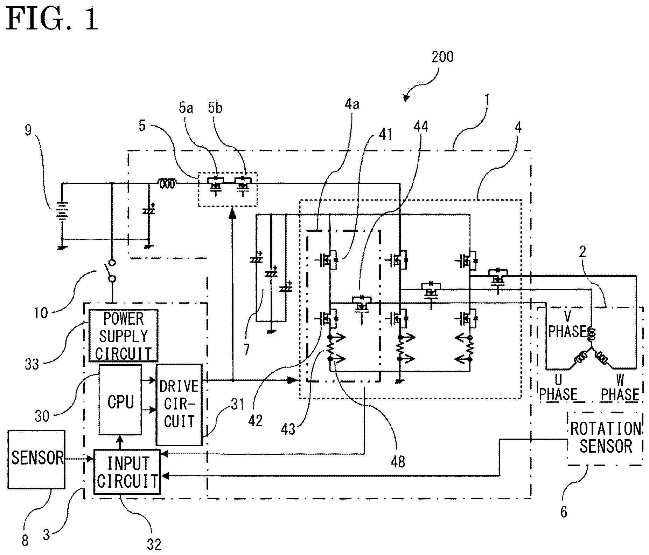

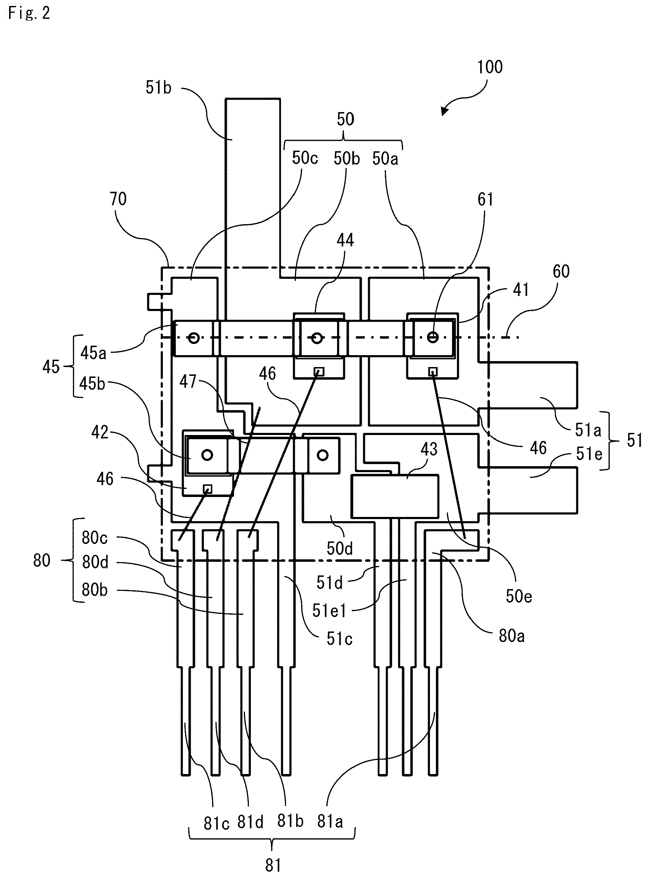

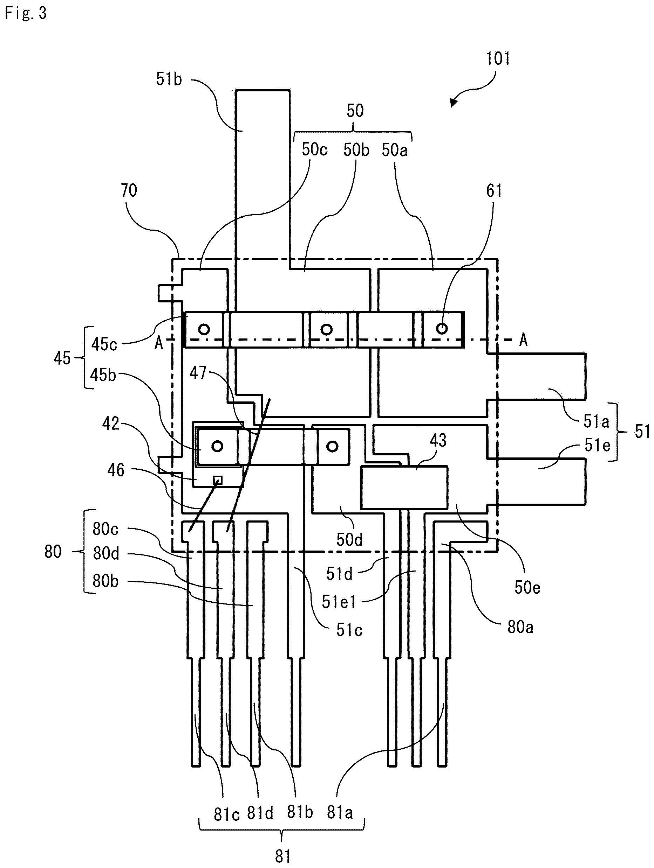

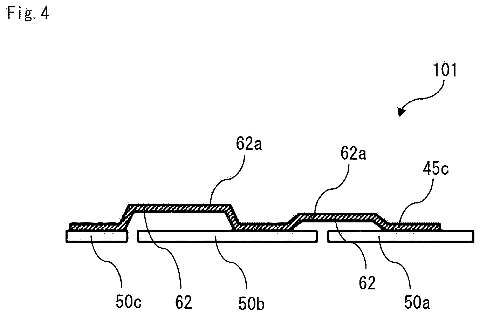

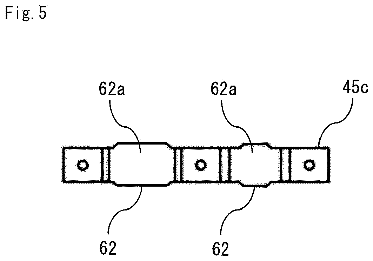

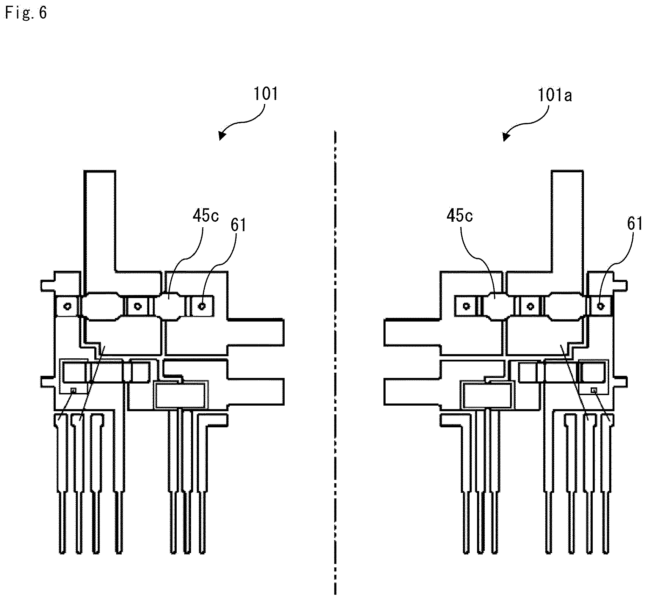

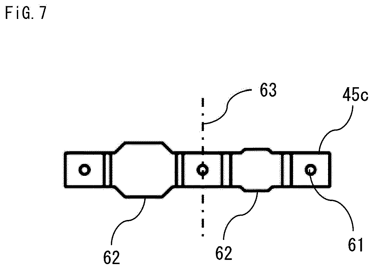

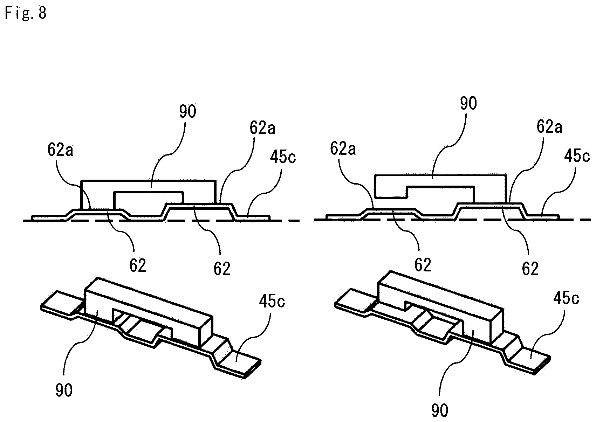

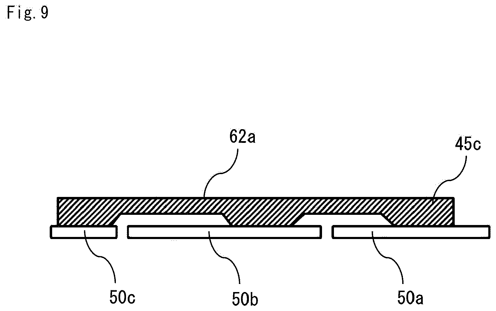

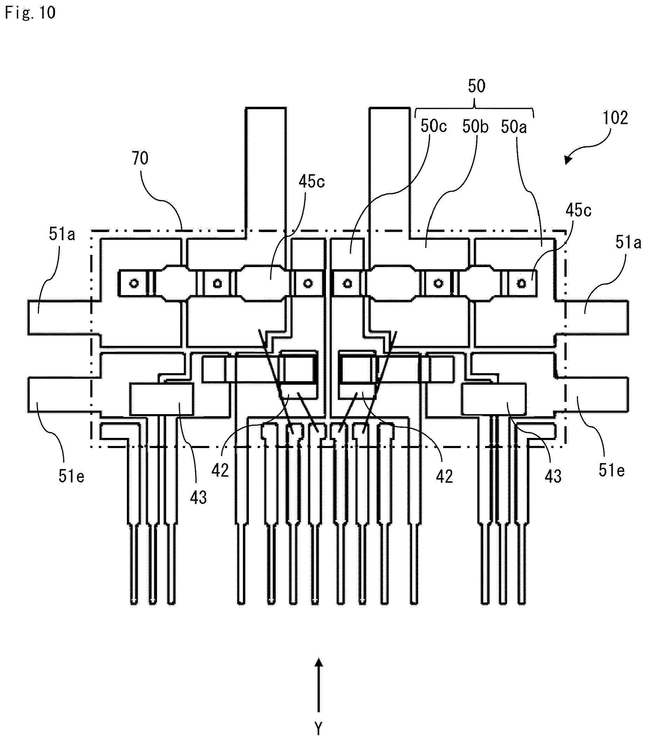

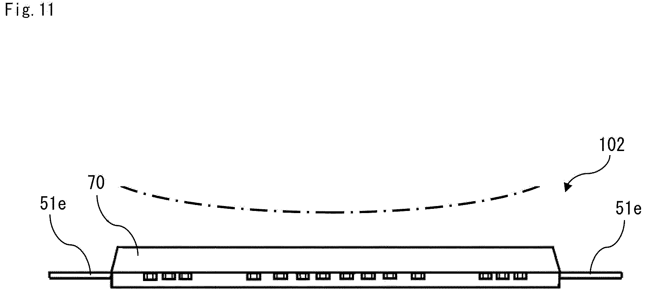

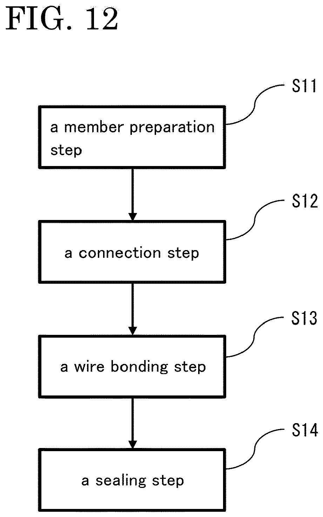

FIG. 1 shows a circuit configuration of the entire system of an electric power steering device 200 including a semiconductor module 100 according to embodiment 1. FIG. 2 is a plan view showing an internal configuration of the semiconductor module 100. FIG. 3 is a side view showing an internal configuration of another semiconductor module 101 according to embodiment 1. FIG. 4 is a sectional view of the semiconductor module 100 taken at an A-A cross-section position in FIG. 3. FIG. 5 is a plan view of another connection member 45c of the semiconductor module 101 according to embodiment 1. FIG. 6 is a plan view of another semiconductor module 101a according to embodiment 1. FIG. 7 is a plan view of another connection member 45c of the semiconductor module 101. FIG. 8 illustrates the connection member 45c of the semiconductor module 101. FIG. 9 is a sectional view of another connection member 45c of the semiconductor module 101 taken at a position equivalent to FIG. 4. FIG. 10 is a plan view of another semiconductor module 102 according to embodiment 1. FIG. 11 is a side view of the other semiconductor module 102 shown in FIG. 10, as seen in a direction of an arrow Y shown in FIG. 10. FIG. 12 shows a manufacturing process for the semiconductor module 100. The plan view of the semiconductor module is a view in which mold resin 70 is removed, and a two-dot dashed line indicates the outer shape of the mold resin 70. The semiconductor module 100 is used in a device for performing power conversion, or the like, and is a module including a semiconductor switching element which is one or a plurality of semiconductor elements for performing power conversion.

### <Electric power steering device 200>

The electric power steering device 200 will be described as an example of a device including the semiconductor module 100. The electric power steering device 200 is a device that converts power supplied from a battery 9 and outputs the converted power to a motor 2. As shown in FIG. 1, the electric power steering device 200 includes a control unit 1, the motor 2, the battery 9, an ignition switch 10, and sensors such as a rotation sensor 6. The motor 2 is a brushless motor having three-phase windings (U phase, V phase, W phase). The rotation sensor 6 is located near the motor 2, detects a rotation angle of the motor 2, and outputs the rotation angle to a control circuit 3 that the control unit 1 has. A sensor 8 includes a torque sensor for detecting a steering wheel operation force, a vehicle speed sensor, and the like. An electric signal corresponding to a physical quantity detected by each sensor is outputted to the control circuit 3.

The control unit 1 is composed of the control circuit 3 including a CPU 30, an inverter circuit 4 which supplies current to the windings of the motor 2, a power supply relay 5, and other electric components. The control unit 1 is connected to the battery 9 and the ignition switch 10, and power is supplied to the control unit 1 via the battery 9 and the ignition switch 10. The control unit 1 is connected to the rotation sensor 6 and the sensor 8, and electric signals outputted from these sensors are inputted to the control circuit 3 that the control unit 1 has.

The control circuit 3 is composed of the CPU 30, a driving circuit 31, an input circuit 32, and a power supply circuit 33 connected to these circuits. The input circuit 32 receives output signals from the rotation sensor 6 and the sensor 8, and outputs data such as rotation angle information about the motor 2 obtained from the output signals, to the CPU 30. The CPU 30 calculates a current value for rotating the motor 2 from the inputted data. The CPU 30 outputs a control signal according to a calculation result, to the inverter circuit 4 via the driving circuit 31. In addition, the CPU 30 receives a current detection signal detected at the inverter circuit 4, via the input circuit 32, and the CPU 30 performs feedback control of the inverter circuit 4 on the basis of the current detection signal.

The inverter circuit 4 is composed of bridge circuits respectively corresponding to the three-phase windings for U phase, V phase, and W phase that the motor 2 has. All the bridge circuits corresponding to the respective phases are the same circuit, and therefore a bridge circuit 4a for one phase (U phase) will be described. The bridge circuit 4a includes three semiconductor switching elements 41, 42, 44. The semiconductor switching element 41 on a high-potential side and the semiconductor switching element 42 on a low-potential side are connected in series. One side of the semiconductor switching element 44 is connected to an intermediate connection part between the semiconductor switching element 41 and the semiconductor switching element 42, and another side of the semiconductor switching element 44 is connected to the coil for U phase of the motor 2. The semiconductor switching element 44 has a relay function capable of connection or disconnection between the coil for U phase and the inverter circuit 4.

A shunt resistor 43 for detecting current is connected to the downstream side of the semiconductor switching element 42 on the low-potential side. A potential difference between both ends of the shunt resistor 43 is detected and converted to a current value. For detecting the potential difference between both ends of the shunt resistor 43, the inverter circuit 4 is provided with terminals 48 at both ends of the shunt resistor 43. Monitoring signals at various points of the inverter circuit 4 are inputted to the CPU 30 via the input circuit 32. Driving of the semiconductor switching elements 41, 42, 44 is controlled on the basis of signals outputted from the driving circuit 31 in accordance with a command from the CPU 30.

The power supply relay 5 is located on the upstream side of the inverter circuit 4. The power supply relay 5 includes two semiconductor switching elements 5a, 5b connected in series. The power supply relay 5 has a relay function capable of supplying or interrupting power to the inverter circuit 4. Smoothing capacitors 7 are connected in parallel between the ground and the power supply to the inverter circuit 4.

In a case of forming the control unit 1 using a semiconductor module including one or a plurality of semiconductor switching elements, various types are assumed. An example thereof is a semiconductor module including the bridge circuits forming the inverter circuit 4, a semiconductor module including the power supply relay 5, or a semiconductor module including a circuit in which some of the shunt resistors and the semiconductor switching elements are omitted.

### <Semiconductor module 100>

A case where the bridge circuit 4a for one phase is formed as the semiconductor module 100 will be described. As shown in FIG. 2, the semiconductor module 100 includes a plurality of base plates 50 formed in plate shapes, control terminals 80, a semiconductor switching element which is at least one semiconductor element joined to a one-surface side of at least one of the base plates 50, and at least one connection member 45 connecting one-surface sides of two or more of the base plates 50. The base plates 50 and the control terminals 80 are conductive members made of the same material such as copper or a copper alloy. The base plates 50 and the control terminals 80 are provided so as to be arranged with gaps therebetween on the same plane. Here, five base plates 50 and four control terminals 80 are provided. Two connection members 45 are provided. The details of the connection member 45 will be described later. The semiconductor module 100 shown in FIG. 2 includes three semiconductor switching elements 41, 42, 44 and further includes the shunt resistor 43. Here, the semiconductor switching elements 41, 42, 44 are field effect transistors (FET). The semiconductor elements joined to the base plates 50 are not limited to semiconductor switching elements.

The semiconductor switching element 41 on the high-potential side is joined to the one-surface of a base plate 50a, at a drain portion of the semiconductor switching element 41. The semiconductor switching element 42 on the low-potential side is joined to the one-surface of a base plate 50c, at a drain portion of the semiconductor switching element 42. The semiconductor switching element 44 is joined to the one-surface of a base plate 50b, at a drain portion of the semiconductor switching element 44. The shunt resistor 43 is joined across to the one-surfaces of a base plate 50d and a base plate 50e.

Each base plate 50 has a terminal portion 51 exposed to outside from a side surface of the mold resin 70. The direction in which the terminal portion 51 is exposed is a direction parallel to the same plane on which the base plates 50 are provided. A terminal portion 51a of the base plate 50a is connected to the battery 9 which is a power supply. A terminal portion 51e of the base plate 50e is connected to the ground. A terminal portion 51b of the base plate 50b is connected to U phase of the motor 2 which is a load, and converted power is outputted from the terminal portion 51b to U phase of the motor 2. The terminal portions 51a, 51b, 51e are large-current power terminals through which a large amount of current flows. The terminal portion 51a and the terminal portion 51e are provided so as to be arranged on the right side of the semiconductor module 100 in FIG. 2. The terminal portion 51b is provided so as to extend upward of the semiconductor module 100 in FIG. 2.

The base plate 50d and the base plate 50e have a terminal portion 51d and a terminal portion 51e1 for detecting voltage between both ends of the shunt resistor 43. The terminal portion 51e and the terminal portion 51e1 have a potential of the ground. The base plate 50c has a terminal portion 51c connected to a connection point among the semiconductor switching elements 41, 42, 44. The terminal portion 51c is a terminal for monitoring a potential at the connection point among the semiconductor switching elements 41, 42, 44.

Each of the plate-shaped control terminals 80 includes a terminal portion 81 exposed to outside from a side surface of the mold resin 70. The direction in which the terminal portion 81 is exposed is a direction parallel to the same plane on which the control terminals 80 are provided. The control terminals 80 are terminals through which a comparatively small amount of current flows and which are used for control of the semiconductor module 100. The control terminals 80 are provided so as to be arranged on the lower side of the semiconductor module 100 in FIG. 2. Control terminals 80a, 80b, 80c are gate control terminals connected to gate portions that the semiconductor switching elements 41, 42, 44 respectively have. The control terminals 80a, 80b, 80c and the respective gate portions are connected via bonding wires 46 provided through a wire bonding process.

The wire bonding is performed from the respective gate portions of the semiconductor switching elements 41, 42, 44 as start points to the control terminal 80 sides as end points. Thus, in the wire bonding process, the bonding wires 46 can be cut without damaging the semiconductor switching elements 41, 42, 44. A control terminal 80d and the base plate 50b are connected via a bonding wire 47. The control terminal 80d is a terminal for monitoring the potential of the terminal portion 51b for output to the motor 2.

The mold resin 70 seals the base plates 50, the control terminals 80, the semiconductor switching elements 41, 42, 44, the shunt resistor 43, the connection members 45, and the bonding wires 46, 47. The outer shape of the mold resin 70 is a rectangular plate shape having a plate surface parallel to the same plane on which the base plates 50 are provided. The other-surfaces of the base plates 50 may be exposed from the mold resin 70 so that the base plates 50 are readily cooled.

### <Semiconductor module 101>

Another semiconductor module 101 shown in FIG. 3 will be described. The semiconductor module 100 has three semiconductor switching elements 41, 42, 44, whereas the semiconductor module 101 has only one semiconductor switching element 42. The semiconductor module 100 and the semiconductor module 101 have the same base plates 50, and the base plates 50 are used in common between the semiconductor module 100 and the semiconductor module 101. The semiconductor module 100 has two connection members 45a, 45b, and the semiconductor module 101 has two connection members 45c, 45b. Since the semiconductor module 100 has the connection member 45a and the semiconductor module 101 has the connection member 45c, the base plates 50 are used in common between the semiconductor module 100 and the semiconductor module 101. Hereinafter, the details of the connection member 45 which is a major part of the present disclosure will be described.

### <Connection member 45>

The connection member 45 has one or both of a semiconductor element connection portion which is a part connected to the base plate 50 via the semiconductor switching element, and a base plate connection portion which is a part directly connected to the base plate 50. The connection member 45 is formed in a bridge shape by a copper plate, for example. The connection member 45a shown in FIG. 2 connects a source portion of the semiconductor switching element 41, a source portion of the semiconductor switching element 44, and the base plate 50c. The connection member 45a has two semiconductor element connection portions and one base plate connection portion. The connection member 45b connects a source portion of the semiconductor switching element 42 and the base plate 50d. The connection member 45b has one semiconductor element connection portion and one base plate connection portion. The connection member 45c shown in FIG. 3 connects the base plate 50a, the base plate 50b, and the base plate 50c. The connection member 45c has three base plate connection portions. Even in a case where semiconductor modules are different in the number of semiconductor switching elements joined to the base plates 50 and connected to the connection member 45, since the connection member 45c has three base plate connection portions, different circuit patterns can be formed with the base plates 50 used in common. In addition, since the base plates 50 are used in common, the semiconductor module is not a product-by-product individual semiconductor module, so that productivity of the semiconductor module can be improved.

In FIG. 2, the semiconductor module 100 has three semiconductor switching elements 41, 42, 44, and the connection member 45a has two semiconductor element connection portions and one base plate connection portion. In a case where the semiconductor module 100 has two semiconductor switching elements 42, 44, if the connection member 45a is formed in a shape having one semiconductor element connection portion and two base plate connection portions, the base plates 50 can be used in common. In the present embodiment, an example in which the connection member 45 has only semiconductor element connection portions is not shown, but depending on the circuit pattern, the connection member 45 may have only semiconductor element connection portions.

In FIG. 3, the base plates 50a, 50b having no semiconductor switching elements are connected by the connection member 45c, whereby, when the base plate 50a generates heat, the heat generated at the base plate 50a can be dissipated to the adjacent base plate 50b connected by the connection member 45c.

The connection member 45 and the semiconductor switching element are connected by solder, for example. The connection member 45 and the base plate 50 are connected by solder, for example. The connection member 45 has, at respective centers of the semiconductor element connection portion and the base plate connection portion, through holes 61 penetrating in the normal directions of the one-surfaces of the base plates 50. With this configuration, at the time of connecting the connection member 45, it is possible to reduce a solder void which could be produced when solder is applied to a connected side and the connection member 45 is connected.

As shown in FIG. 4, the connection member 45c has, at a part connected between two base plates 50, a flat portion 62 which is spaced apart from the one-surface of the base plate 50 and whose surface on the side opposite to the base plate 50 side is parallel to the one-surface of the base plate 50. With this configuration, it is possible to use a parallel surface 62a of the flat portion 62 parallel to the one-surface of the base plate 50, for a jig or the like used in assembling the semiconductor module 100, 101. Since the parallel surface 62a can be used in assembling the semiconductor module 100, 101, productivity of the semiconductor module 100, 101 can be improved.

As shown in FIG. 5, the connection member 45c may be formed in a plate shape, and the width of the flat portion 62 may be greater than the width of the semiconductor element connection portion and the width of the base plate connection portion. With this configuration, since the parallel surface 62a to be used in assembling the semiconductor module 100, 101 is enlarged, the parallel surface 62a can be easily used in assembling and therefore the position of the connection member 45c can be stabilized in assembling. Since the position of the connection member 45c is stabilized in assembling, productivity of the semiconductor module 100, 101 can be improved.

As shown in FIG. 2, a plurality of the through holes 61 are provided so as to be arranged in one direction, and the connection member 45 extends in the direction in which the plurality of through holes 61 are arranged. With this configuration, since the connection member 45 is formed in a simple shape which is not complicated, yield of the connection member 45 can be improved. In addition, since the plurality of through holes 61 are provided so as to be arranged in one direction, the distance between parts connected by the connection member 45 can be shortened.

In addition, as seen in a direction perpendicular to the one-surfaces of the base plates 50, the connection member 45a is formed to be line-symmetric with respect to a line (center line 60 in FIG. 2) connecting respective centers of the plurality of through holes 61. With this configuration, the connection member 45a can be easily balanced in assembling, whereby position displacement of the connection member 45a can be suppressed. Since position displacement of the connection member 45a is suppressed, productivity of the semiconductor module 100, 101 can be improved.

FIG. 6 shows another semiconductor module 101a formed in a mirror-symmetric shape with respect to the other semiconductor module 101 shown in FIG. 3, together with the semiconductor module 101. The plurality of through holes 61 are provided so as to be arranged in one direction, and the connection member 45c extends in the direction in which the plurality of through holes 61 are arranged. Therefore, even in a case where the semiconductor module 101a has a mirror-symmetric shape and the base plates 50 also have mirror-symmetric shapes, the connection member 45c can be used in common by mounting the connection member 45c in a mirror-symmetric form.

In addition, in a case where the through holes 61 that the connection member 45 has are provided so as to be arranged in one direction, in assembling the semiconductor module, it is possible to stabilize the position of the connection member 45 at the time of mounting the connection member 45 by manufacturing equipment. In a case where the through holes 61 are not provided so as to be arranged in one direction, the connection member 45 cannot be formed in a straight shape and the connection member 45 is formed in a bent shape. If the connection member 45 has a bent shape, the connection member 45 is likely to rotate due to air resistance at the time of mounting the connection member 45. Thus, the bent connection member 45 becomes unstable regarding its position, at the time of being mounted. If the through holes 61 are provided so as to be arranged in one direction, the connection member 45 can be formed in a straight shape. Thus, air resistance that the connection member 45 receives becomes uniform, so that the position of the connection member 45 at the time of mounting thereof can be stabilized.

As shown in FIG. 7, the plurality of through holes 61 are provided so as to be arranged in one direction, the connection member 45c extends in the direction in which the plurality of through holes 61 are arranged, and as seen in the direction perpendicular to the one-surfaces of the base plates 50, the connection member 45c is formed to be left-right asymmetric with respect to an axis 63 perpendicular to the extending direction of the connection member 45c at the through hole 61 located at the center among the plurality of through holes 61. The connection member 45c shown in FIG. 7 is formed to be left-right asymmetric such that the sizes of the flat portions 62 provided on the right and left sides of the axis 63 are different from each other. The configuration for forming the connection member 45c to be left-right asymmetric is not limited to the above, and the connection member 45c may be formed to be left-right asymmetric such that the sizes of the semiconductor element connection portions or the base plate connection portions of the connection member 45c are different from each other. With this configuration, it is possible to prevent the connection member 45c from being connected in a left-right opposite way in assembling.

As shown in FIG. 8, the connection member 45c has at least two flat portions 62, and heights from the one-surfaces of the base plates 50 to the two flat portions 62 are different from each other. The one-surfaces of the base plates 50 are parts indicated by a broken line in FIG. 8. FIG. 8 shows an example in which the connection member 45c has two flat portions 62. As shown on the left side in FIG. 8, for a jig 90 used in assembling the semiconductor module 101, the parallel surfaces 62a of the two flat portions 62 parallel to the one-surfaces of the base plates 50 can be used at the same time. By using the two parallel surfaces 62a at the same time, the position of the connection member 45c can be further stabilized in assembling. In addition, in a case where the connection member 45c is placed in an opposite way in assembling, since the heights of the two flat portions 62 are different from each other, as shown on the right side in FIG. 8, a gap is formed between the jig 90 and the flat portion 62 and therefore the connection member 45c cannot be retained by the jig 90. Since the connection member 45c cannot be retained by the jig 90, the connection member 45c can be prevented from being placed at an abnormal position. Since abnormal placement of the connection member 45c is prevented, productivity of the semiconductor module 100, 101 can be improved.

The connection member 45 described above is formed in a plate shape, but the shape of the connection member 45 is not limited to a plate shape. As shown in FIG. 9, the shape may be such a spatial shape that a surface of the connection member 45c on the side opposite to the base plate 50 side is parallel to the one-surfaces of the base plates 50, and connection portions of the connection member 45c with the base plates 50 protrude toward the base plate 50 side. Since the parallel surface 62a parallel to the one-surfaces of the base plates 50 is enlarged, the parallel surface 62a can be easily used in assembling and therefore the position of the connection member 45c can be stabilized in assembling. In addition, forming the connection member 45c in a spatial shape which is not a plate shape increases the volume of the connection member 45c, whereby rigidity of the connection member 45c can be increased.

The semiconductor module 102 shown in FIG. 10 is configured such that two semiconductor modules arranged to be mirror-symmetric are sealed with the mold resin 70. As seen in the direction perpendicular to the one-surfaces of the base plates 50, the outer shape of the mold resin 70 is a rectangular shape having long sides and short sides, and the connection members 45c extend in a direction parallel to the long-side direction of the mold resin 70. In FIG. 10, the long sides are formed in the left-right direction of the drawing, and the short sides are formed in the up-down direction of the drawing. The connection members 45c are provided so as to extend in the left-right direction of the drawing. In a case where the outer shape of the mold resin 70 is a rectangular shape having long sides and short sides as seen in the direction perpendicular to the one-surfaces of the base plates 50, the mold resin 70 might be warped along the long sides during molding, as shown in FIG. 11. A dotted-dashed line shown in FIG. 11 indicates an example of the warping direction of the mold resin 70. When the mold resin 70 is warped, an end position of each terminal might be shifted along with the warping. Therefore, it is important to suppress occurrence of warp. In a case where the connection members 45c extend in the direction parallel to the long-side direction of the mold resin 70, occurrence of warp can be suppressed. In a case where the connection members 45c have the shape shown in FIG. 9, rigidity of the connection members 45c is high and thus occurrence of warp can be further suppressed.

### <Method for manufacturing semiconductor module 100>

A method for manufacturing the semiconductor module 100 will be described with reference to FIG. 12. The semiconductor module 100 is manufactured through a member preparation step (S11), a connection step (S12), a wire bonding step (S13), and a sealing step (S14). Hereinafter, each step of the method for manufacturing the semiconductor module 100 shown in FIG. 2 will be mainly described, but the same applies to methods for manufacturing the semiconductor modules 101, 102 which are other semiconductor modules.

The member preparation step is a step of preparing a plurality of base plates 50 which are made of conductive members and formed in plate shapes and which are arranged with gaps therebetween on the same plane, at least one semiconductor element, and at least one connection member 45 made of a conductive member. For the semiconductor module 100, five base plates 50, the semiconductor switching elements 41, 42, 43 which are three semiconductor elements, and two connection members 45a, 45b are prepared. In addition to the above members, for the semiconductor module 100, four control terminals 80 and the shunt resistor 43 are prepared. The four control terminals 80 are arranged with gaps therebetween on the same plane, together with the five base plates 50.

The connection step is a step of connecting one-surface sides of two or more of the base plates 50 by the connection member 45 via the semiconductor switching element or not via the semiconductor switching element. In the connection step, a plurality of connection parts between the base plates 50 and the connection member 45 are each connected by an indirect connection method so as to be connected via the semiconductor switching element joined to the base plate 50 or by a direct connection method so as to be directly connected not via the semiconductor switching element. Therefore, in the connection step, a first connection step of performing connection for the plurality of connection parts by a first setting pattern of the indirect connection method and the direct connection method, and a second connection step of performing connection for the plurality of connection parts by a second setting pattern of the indirect connection method and the direct connection method, which is different from the first setting pattern, are executed.

For the semiconductor module 100, the first connection step is executed by the first setting pattern. The first setting pattern is a pattern in which three connection parts of the connection member 45a are connected by two indirect connection methods and one direct connection method, and two (a plurality of) connection parts of the connection member 45b are connected by one indirect connection method and one direct connection method. For the semiconductor module 101, the second connection step is executed by the second setting pattern. The second setting pattern is a pattern in which three connection parts of the connection member 45c are connected by three direct connection methods, and two (a plurality of) connection parts of the connection member 45b are connected by one indirect connection method and one direct connection method. For the semiconductor module 100, the connection members 45a, 45b are prepared in the member preparation step, and for the semiconductor module 101, the connection members 45c, 45b are prepared in the member preparation step.

In the first connection step, the semiconductor element connection portion of the connection member 45a and the semiconductor switching element 41, the semiconductor element connection portion of the connection member 45a and the semiconductor switching element 44, and the base plate connection portion of the connection member 45a and the base plate 50c, are respectively connected, and the semiconductor element connection portion of the connection member 45b and the semiconductor switching element 42, and the base plate connection portion of the connection member 45b and the base plate 50d, are respectively connected. In the second connection step, the base plate connection portion of the connection member 45c and the base plate 50a, the base plate connection portion of the connection member 45c and the base plate 50b, and the base plate connection portion of the connection member 45c and the base plate 50c, are respectively connected, and the semiconductor element connection portion of the connection member 45b and the semiconductor switching element 42, and the base plate connection portion of the connection member 45b and the base plate 50d, are respectively connected. In addition, for the semiconductor module 100, in the connection step, the shunt resistor 43 is joined to the base plates 50d, 50e.

By providing the connection step as described above, the base plates 50 can be used in common even for semiconductor modules that are different in the number of semiconductor elements joined to the base plates 50 and connected to the connection member 45. Since the base plates 50 are used in common, the semiconductor module is not a product-by-product individual semiconductor module, so that productivity of the semiconductor module can be improved.

The wire bonding step is a step of connecting each control terminal 80 and the semiconductor switching element or the base plate by a bonding wire. For the semiconductor module 100, the control terminals 80a, 80b, 80c and the gate portions that the semiconductor switching elements 41, 42, 44 respectively have, are connected by the bonding wires 46. Further, the control terminal 80d and the base plate 50b are connected by the bonding wire 47.

The sealing step is a step of sealing the base plates 50, the control terminals 80, the semiconductor switching elements 41, 42, 44, the shunt resistor 43, the connection members 45, and the bonding wires 46, 47 with the mold resin 70. After the sealing step, the terminal portions 51 of the base plates 50 and the terminal portions 81 of the control terminals 80 are exposed to outside from side surfaces of the mold resin 70.

As described above, the semiconductor module 100 according to embodiment 1 includes a plurality of base plates 50 formed in plate shapes, at least one semiconductor element joined to a one-surface side of at least one of the base plates 50, and at least one connection member 45 connecting one-surface sides of two or more of the base plates 50. The plurality of base plates 50 are arranged with gaps therebetween on the same plane. The connection member 45 has one or both of a semiconductor element connection portion which is a part connected to the base plate 50 via the semiconductor element, and a base plate connection portion which is a part directly connected to the base plate 50. Thus, the base plates 50 can be used in common even for semiconductor modules that are different in the number of semiconductor elements joined to the base plates 50 and connected to the connection member 45. Since the base plates 50 are used in common, the semiconductor module is not a product-by-product individual semiconductor module, so that productivity of the semiconductor module can be improved.

The connection member may have, at a part connected between two base plates 50, the flat portion 62 which is spaced apart from the one-surface of the base plate 50 and whose surface on the side opposite to the base plate 50 side is parallel to the one-surface of the base plate 50. Thus, it is possible to use the parallel surface 62a of the flat portion 62 parallel to the one-surface of the base plate 50, for a jig or the like used in assembling the semiconductor module 100, whereby productivity of the semiconductor module 100 can be improved.

The connection member 45c may be formed in a plate shape, and the width of the flat portion 62 may be greater than the width of the semiconductor element connection portion and the width of the base plate connection portion. Thus, since the parallel surface 62a to be used in assembling the semiconductor module 100 is enlarged, the parallel surface 62a can be easily used in assembling and therefore the position of the connection member 45 can be stabilized in assembling.

The connection member 45c may have at least two flat portions 62, and heights from the one-surfaces of the base plates 50 to the two flat portions 62 may be different from each other. Thus, when the connection member 45c is placed in an opposite way in assembling, a gap is formed between the jig 90 and the flat portion 62 and therefore the connection member 45c cannot be retained by the jig 90. Accordingly, the connection member 45c can be prevented from being placed at an abnormal position. The connection member 45 may have, at respective centers of the semiconductor element connection portion and the base plate connection portion, the through holes 61 penetrating in the normal directions of the one-surfaces of the base plates 50. With this configuration, at the time of connecting the connection member 45, it is possible to reduce a solder void which could be produced when solder is applied to a connected side and the connection member 45 is connected.

A plurality of the through holes 61 may be provided so as to be arranged in one direction, the connection member 45a may extend in the direction in which the plurality of through holes 61 are arranged, and as seen in the direction perpendicular to the one-surfaces of the base plates 50, the connection member 45a may be formed to be line-symmetric with respect to a line connecting respective centers of the plurality of through holes 61. Thus, the connection member 45a can be easily balanced in assembling, whereby position displacement of the connection member 45a can be suppressed. The plurality of through holes 61 may be provided so as to be arranged in one direction, the connection member 45c may extend in the direction in which the plurality of through holes 61 are arranged, and as seen in the direction perpendicular to the one-surfaces of the base plates 50, the connection member 45c may be formed to be left-right asymmetric with respect to the axis 63 perpendicular to the extending direction of the connection member 45c at the through hole 61 located at the center among the plurality of through holes 61. Thus, it is possible to prevent the connection member 45c from being connected in a left-right opposite way in assembling.

The semiconductor module 100 may further include the mold resin 70 sealing the plurality of base plates 50, the semiconductor switching element, and the connection member 45. As seen in the direction perpendicular to the one-surfaces of the base plates 50, the outer shape of the mold resin 70 may be a rectangular shape having long sides and short sides, and the connection member 45 may extend in the direction parallel to the long-side direction of the mold resin 70. Thus, warp that occurs along the long sides of the mold resin 70 in molding can be suppressed.

The surface of the connection member 45c on the side opposite to the base plate 50 side may be parallel to the one-surfaces of the base plates 50, and connection portions of the connection member 45c with the base plates 50 may protrude toward the base plate 50 side. Thus, since the parallel surface 62a parallel to the one-surfaces of the base plates 50 is enlarged, the parallel surface 62a can be easily used in assembling and therefore the position of the connection member 45c can be stabilized in assembling. In addition, forming the connection member 45c in a spatial shape which is not a plate shape increases the volume of the connection member 45c, whereby rigidity of the connection member 45c can be increased.

The method for manufacturing the semiconductor module 100 according to embodiment 1 includes the member preparation step, and the connection step of connecting one-surface sides of two or more of the base plates 50 by the connection member 45 via the semiconductor switching element or not via the semiconductor switching element. In the connection step, a plurality of connection parts between the base plates 50 and the connection member 45 are each connected by the indirect connection method so as to be connected via the semiconductor switching element or by the direct connection method so as to be directly connected not via the semiconductor switching element, and the first connection step of performing connection for the plurality of connection parts by the first setting pattern of the indirect connection method and the direct connection method, and the second connection step of performing connection for the plurality of connection parts by the second setting pattern of the indirect connection method and the direct connection method, which is different from the first setting pattern, are executed. Thus, the base plates 50 can be used in common even for semiconductor modules that are different in the number of semiconductor switching elements joined to the base plates 50 and connected to the connection member 45. Since the base plates 50 are used in common, the semiconductor module is not a product-by-product individual semiconductor module, so that productivity of the semiconductor module can be improved.

Although the disclosure is described above in terms of various exemplary embodiments and implementations, it should be understood that the various features, aspects, and functionality described in one or more of the individual embodiments are not limited in their applicability to the particular embodiment with which they are described, but instead can be applied, alone or in various combinations to one or more of the embodiments of the disclosure.

It is therefore understood that numerous modifications which have not been exemplified can be devised without departing from the scope of the present disclosure. For example, at least one of the constituent components may be modified, added, or eliminated. At least one of the constituent components mentioned in at least one of the preferred embodiments may be selected and combined with the constituent components mentioned in another preferred embodiment.

### DESCRIPTION OF THE REFERENCE CHARACTERS

- 1: control unit
- 2: motor
- 3: control circuit
- 4: inverter circuit
- 4a: bridge circuit
- 5: power supply relay
- 5a: semiconductor switching element
- 5b: semiconductor switching element
- 6: rotation sensor
- 7: capacitor
- 8: sensor
- 9: battery
- 10: ignition switch
- 30: CPU
- 31: driving circuit
- 32: input circuit
- 33: power supply circuit
- 41: semiconductor switching element
- 42: semiconductor switching element
- 43: shunt resistor
- 44: semiconductor switching element
- 45: connection member
- 46: bonding wire
- 47: bonding wire
- 48: terminal
- 50: base plate
- 51: terminal portion
- 60: center line
- 61: through hole
- 62: flat portion
- 62a: parallel plane
- 63: axis
- 70: mold resin
- 80: control terminal
- 81: terminal portion
- 90: jig
- 100: semiconductor module
- 101: semiconductor module
- 102: semiconductor module
- 200: electric power steering device

## Claims

1. A semiconductor module comprising:
a plurality of base plates made of conductive members and formed in plate shapes;
at least one semiconductor element joined to a one-surface side of at least one of the base plates; and
at least one connection member made of a conductive member and connecting one-surface sides of two or more of the base plates, wherein
the plurality of base plates are arranged with gaps therebetween on the same plane, and
the connection member has one or both of a semiconductor element connection portion which is a part connected to the base plate via the semiconductor element, and a base plate connection portion which is a part directly connected to the base plate.

2. The semiconductor module according to claim 1, wherein
the connection member has, at a part connected between the two base plates, a flat portion which is spaced apart from the one-surface of the base plate and whose surface on a side opposite to the base plate side is parallel to the one-surface of the base plate.

3. The semiconductor module according to claim 2, wherein
the connection member is formed in a plate shape, and a width of the flat portion is greater than a width of the semiconductor element connection portion and a width of the base plate connection portion.

4. The semiconductor module according to claim 2 or 3, wherein
the connection member has at least two said flat portions, and
heights from the one-surfaces of the base plates to the two flat portions are different from each other.

5. The semiconductor module according to any one of claims 1 to 4, wherein
the connection member has, at respective centers of the semiconductor element connection portion and the base plate connection portion, through holes penetrating in normal directions of the one-surfaces of the base plates.

6. The semiconductor module according to claim 5, wherein
a plurality of the through holes are provided so as to be arranged in one direction,
the connection member extends in the direction in which the plurality of through holes are arranged, and
as seen in a direction perpendicular to the one-surfaces of the base plates, the connection member is formed to be line-symmetric with respect to a line connecting respective centers of the plurality of through holes.

7. The semiconductor module according to claim 5 or 6, wherein
a plurality of the through holes are provided so as to be arranged in one direction,
the connection member extends in the direction in which the plurality of through holes are arranged, and
as seen in a direction perpendicular to the one-surfaces of the base plates, the connection member is formed to be left-right asymmetric with respect to an axis perpendicular to the extending direction of the connection member at the through hole located at a center among the plurality of through holes.

8. The semiconductor module according to any one of claims 1 to 7, further comprising mold resin sealing the plurality of base plates, the semiconductor element, and the connection member, wherein
as seen in a direction perpendicular to the one-surfaces of the base plates, an outer shape of the mold resin is a rectangular shape having long sides and short sides, and
the connection member extends in a direction parallel to the long-side direction of the mold resin.

9. The semiconductor module according to claim 1, wherein
a surface of the connection member on a side opposite to the base plate side is parallel to the one-surfaces of the base plates, and connection portions of the connection member with the base plates protrude toward the base plate side.

10. A method for manufacturing a semiconductor module, the method comprising:
a member preparation step of preparing a plurality of base plates which are made of conductive members and formed in plate shapes and which are arranged with gaps therebetween on the same plane, at least one semiconductor element, and at least one connection member made of a conductive member; and
a connection step of connecting one-surface sides of two or more of the base plates by the connection member via the semiconductor element or not via the semiconductor element, wherein
in the connection step,
a plurality of connection parts between the base plates and the connection member are each connected by an indirect connection method so as to be connected via the semiconductor element or by a direct connection method so as to be directly connected not via the semiconductor element, and
a first connection step of performing connection for the plurality of connection parts by a first setting pattern of the indirect connection method and the direct connection method, and a second connection step of performing connection for the plurality of connection parts by a second setting pattern of the indirect connection method and the direct connection method, which is different from the first setting pattern, are executed.
